# EUROPÄISCHE PATENTANMELDUNG

(11) **EP 4 589 193 A1**
(43) Veröffentlichungstag der Anmeldung: **23.07.2025**
(21) Anmeldenummer: 24152668.0
(22) Anmeldetag: 18.01.2024
(51) Int. Cl.: F21S 41/141, F21S 41/19, F21S 41/24, F21S 41/29, F21S 43/14, F21S 43/19, F21S 43/235, F21S 43/27, F21S 45/47

(54) **LICHTMODUL FÜR EIN KRAFTFAHRZEUG SOWIE VERFAHREN ZUM HERSTELLEN EINES LICHTMODULS**

(71) Anmelder: ZKW Group GmbH, 3250 Wieselburg (AT)
(72) Erfinder: Etlinger, Stefan, 3100 St. Pölten (AT); Pritzl, Leopold, 3254 Bergland (AT); Steiner, Eva, 3325 Ferschnitz (AT)
(74) Vertreter: Patentanwaltskanzlei Matschnig & Forsthuber OG

(57) **Zusammenfassung**

Die Erfindung betrifft ein Lichtmodul (1) für ein Kraftfahrzeug, insbesondere einen Kraftfahrzeugscheinwerfer, wobei das Lichtmodul (1) Folgendes umfasst: Eine Leiterplatte (2), zumindest eine an einer Seite der Leiterplatte (2) flächig angeordnete Lichteinheit (3) mit einer Lichtaustrittsfläche (3a) zur Abstrahlung von Licht, wobei die Lichteinheit (3) vorzugsweise zumindest eine LED-Lichtquelle (3b) umfasst, wobei durch die besagte Seite der Leiterplatte (2) eine Leiterplattenebene (yz) ausgebildet wird, wobei die Leiterplatte (2) zumindest eine Abstandselementaufnahmeöffnung (4) aufweist, die in der Umgebung der zumindest einen Lichteinheit (3) angeordnet ist, wobei die zumindest eine Abstandselementaufnahmeöffnung (4) die Leiterplatte (2) durchsetzt und zur Aufnahme eines Abstandselementes (5) eingerichtet ist, sowie zumindest einen Lichtleiter (6).

## Beschreibung

Die Erfindung betrifft ein Lichtmodul für ein Kraftfahrzeug, insbesondere einen Kraftfahrzeugscheinwerfer, wobei das Lichtmodul Folgendes umfasst: Eine Leiterplatte, zumindest einen Lichtleiter, sowie zumindest eine an einer Seite der Leiterplatte flächig angeordnete Lichteinheit mit einer Lichtaustrittsfläche zur Abstrahlung von Licht, wobei die Lichteinheit vorzugsweise zumindest eine LED-Lichtquelle umfasst, wobei durch die besagte Seite der Leiterplatte eine Leiterplattenebene ausgebildet wird.

Lichtleiter können dazu eingesetzt werden, das von der Lichteinheit abgestrahlte Licht von der Leiterplatte ausgehend hin zu einem gewünschten Abstrahlbereich zu führen und innerhalb des Abstrahlbereichs eine gewünschte Lichtverteilung zu erzeugen. Hierzu werden die Lichtleiter typischerweise oberhalb der Lichteinheit direkt an der Leiterplatte abgestützt, und zwar so, dass eine Lichteintrittsfläche des Lichtleiters der Lichteinheit zugeordnet ist.

Durch einen solchen Aufbau entsteht ein Luftspalt zwischen der Lichteintrittsfläche und der Lichteinheit. Die Aufgabe, Lichtmodule mit höhere Leistungsdichte und damit in der Regel geringeren Kosten zu schaffen, steht in der Praxis der technischen Aufgabe, eine hohe Haltbarkeit der Lichteinheit zu erzielen, teilweise diametral gegenüber. So führt eine höhere Leistungsdichte häufig dazu, dass sich die Bauteiltemperaturen erhöhen, wodurch die Haltbarkeit elektronischer Bauteile negativ beeinflusst wird. Um höhere Leistungsdichten bei gleichbleibender Temperaturbelastung zu erzielen, werden daher in der Praxis ausgeklügelte Kühlsysteme eingesetzt. Zudem wird laufend versucht, die Effizienz der in der Lichteinheit eingesetzten Lichtquellen zu erhöhen.

Eine Aufgabe der Erfindung besteht darin, ein Lichtmodul zu schaffen, welches eine Erhöhung der Leistungsdichte ermöglicht.

Diese Aufgabe wird mit einem Lichtmodul der eingangs genannten Art gelöst, bei welchem erfindungsgemäß die Leiterplatte zumindest eine Abstandselementaufnahmeöffnung aufweist, die in der Umgebung der zumindest einen Lichteinheit angeordnet ist, wobei die zumindest eine Abstandselementaufnahmeöffnung die Leiterplatte durchsetzt und zur Aufnahme eines Abstandselementes eingerichtet ist, wobei das Lichtmodul ferner zumindest ein Abstandselement aufweist, das in zumindest einer Abstandselementaufnahmeöffnung angeordnet ist, wobei das zumindest eine Abstandselement zumindest zwei Abschnitte aufweist, nämlich einen die Abstandselementaufnahmeöffnung durchsetzenden Halteabschnitt sowie zumindest einen an einem Ende des Halteabschnitts angeordneten Stützabschnitt, der im Vergleich zu dem Halteabschnitt verbreitert ist und das Abstandselement gegen ein Durchschieben durch die Abstandselementaufnahmeöffnung sichert, wobei der Stützabschnitt an der gleichen Seite der Leiterplatte wie die zumindest eine Lichteinheit angeordnet und an seinem der Leiterplatte abgewandten Ende durch eine ebene Stützfläche begrenzt ist, wobei diese Stützfläche im Wesentlichen parallel zur Leiterplattenebene orientiert ist, wobei der Lichtleiter eine Lichteintrittsfläche aufweist, die der Lichteinheit zur Aufnahme von Licht zugewandt ist, wobei die Lichteintrittsfläche des Lichtleiters von zumindest einem Abstützbereich des Lichtleiters zumindest teilweise umgeben ist, welcher Abstützbereich des Lichtleiters an der Stützfläche des Abstandselements zur Festlegung eines definierten Normalabstands der Lichteintrittsfläche des Lichtleiters in Bezug auf die Lichteinheit abgestützt ist.

Durch den Einsatz des Abstandselements kann ein definierter Mindestabstand zu dem Lichtleiter vorgegeben werden, der unabhängig von der Fertigungs- und Positioniergenauigkeit des Lichtleiters eingehalten wird. Auf diese Weise kann die Temperatur an der Lichteinheit gegenüber einer Variante, in der der Lichtleiter direkt an der Leiterplatte abgestützt ist, im Normalbetrieb um ca. 3 bis 4°C gesenkt werden. Im Detail kann durch Wahl der Ausgestaltung des Abstandselements gezielt Einfluss auf die Größe des Luftspaltes genommen werden. Zudem können Vorsprünge an dem Lichtleiter reduziert werden oder gar entfallen.

Insbesondere kann vorgesehen sein, dass der Stützabschnitt des Abstandselements weiter in Normalrichtung zur Leiterplattenebene von der Leiterplatte absteht als die Lichtaustrittsfläche der Lichteinheit, sodass die Stützfläche die Lichtaustrittfläche in Normalrichtung überragt. Selbst wenn also keine Vorsprünge an einem korrespondierenden Lichtleiter angeordnet sind und die Eintrittsfläche sich eben über den gesamten Querschnitt des Lichtleiters erstreckt, berührt der Lichtleiter in dieser Variante die Lichteinheit nicht.

Weiters kann vorgesehen sein, dass im Abstützbereich des Lichtleiters zumindest ein Vorsprung, vorzugweise zwei Vorsprünge ausgebildet sind, die in Richtung der Stützfläche des Abstandshaltelements von dem Lichtleiter abstehen und sich an der Stützfläche abstützen.

Insbesondere kann vorgesehen sein, dass der Halteabschnitt des Abstandselements dergestalt ausgebildet ist, dass dieser die Abstandselementaufnahmeöffnung formschlüssig ausfüllt. Dadurch kann ein besonders guter Halt des Abstandselements erzielt werden.

Weiters kann vorgesehen sein, dass die zumindest eine Lichteinheit von zumindest zwei, vorzugsweise genau zwei, Abstandselementaufnahmeöffnungen umgeben ist, wobei diese Abstandselementaufnahmeöffnungen dergestalt räumlich um die Lichteinheit angeordnet sind, dass im Falle des Vorhandenseins von genau zwei Abstandselementöffnungen in der Umgebung der Lichteinheit der Mittelpunkt einer gedachten Verbindungslinie zwischen den Abstandselementöffnungen mit dem geometrischen Schwerpunkt der Lichtaustrittsfläche der Lichteinheit im Wesentlichen zusammenfällt, und/oder im Falle des Vorhandenseins von drei oder mehr Abstandselementöffnungen in der Umgebung der Lichteinheit der Schwerpunkt eines gedachten Polygons mit dem geometrischen Schwerpunkt der Lichtaustrittsfläche der Lichteinheit im Wesentlichen zusammenfällt, wobei das gedachte Polygon dergestalt gebildet wird, dass jede in der Umgebung der Lichteinheit befindliche Abstandselementöffnung eine Ecke des Polygons bildet und jede Ecke eine gerade Verbindung zu den zwei nächstgelegenen Ecken aufweist. Auf diese Weise wird eine mechanisch besonders stabile Montageart geschaffen. Im Falle von einer Anzahl von drei Abstandselementöffnungen in der Umgebung der Lichteinheit würde somit ein Dreieck gebildet werden, im Falle von vier Öffnungen ein Viereck, etc.. Es ist dabei von Vorteil, wenn die dergestalt gebildete geometrische Figur die Lichtaustrittfläche der Lichteinheit umschließt. Im Falle von kreisrunder oder quadratischer Lichtabstrahlfläche ist daher ein gleichmäßiger Abstand der Öffnungen zueinander vorteilhaft.

Unter "Umgebung der Lichteinheit" kann ein Abstand von maximal 3 mm gemessen zwischen der Lichteinheit (also ein der Öffnung nächstgelegener Randpunkt davon) und der Abstandselementöffnung (ebenso der zur Lichteinheit nächstgelegene Randpunkt) verstanden werden.

Insbesondere kann vorgesehen sein, dass das Lichtmodul zwei oder mehr Lichteinheiten aufweist, wobei den zwei oder mehr Lichteinheiten je zumindest eine, zwei oder mehr Abstandselementaufnahmeöffnungen mit je einem darin aufgenommenen Abstandselement und je ein Lichtleiter zugeordnet sind.

Weiters kann vorgesehen sein, dass der Stützabschnitt und der Halteabschnitt des Abstandselements jeweils im Wesentlichen zylindrisch mit einer gemeinsamen Längsachse ausgebildet sind.

Insbesondere kann vorgesehen sein, dass der Abstand zwischen einer Abstandselementaufnahmeöffnung und dem nächstgelegenen Punkt einer zugeordneten Lichteinheit maximal 3 mm, insbesondere zwischen 1,5 mm und 3 mm, beträgt. Typischerweise kann der Abstand z.B. 2 mm betragen.

Im Übrigen sei erwähnt, dass jede technische Eigenschaft, die zu einem einzelnen Element erwähnt wurde, auch für mehrere oder alle der Elemente der gleichen Elementart gelten kann. D.h. die genannten Abstände, geometrische Anordnungen zueinander usw. können auf ein Element, zwei oder mehr oder sogar auf alle Elemente anwendbar sein.

Weiters kann vorgesehen sein, dass die Abstandselementaufnahmeöffnung als Bohrung mit einem kreisrunden Lochdurchmesser zwischen 1 mm und 2 mm ausgebildet ist. Typischerweise kann der Durchmesser z.B. 1,2 mm betragen.

Insbesondere kann vorgesehen sein, dass die Querschnittsfläche des Stützabschnitts zumindest das Vierfache der Querschnittsfläche des Halteabschnitts des Abstandselements beträgt.

Weiters kann vorgesehen sein, dass der Halteabschnitt des Abstandselements in der Abstandselementaufnahmeöffnung fest fixiert ist.

Insbesondere kann vorgesehen sein, dass das Abstandselement zudem einen Sicherungsabschnitt aufweist, welcher Sicherungsabschnitt an dem dem Stützabschnitt gegenüberliegenden Ende des Halteabschnitts angeordnet ist, wobei der Sicherungsabschnitt gegenüber dem Halteabschnitt verbreitert ist. Dies kann z.B. durch Spreizen oder Heißverstemmen erfolgen.

Weiters betrifft die Erfindung ein Verfahren zum Herstellen eines erfindungsgemäßen Lichtmoduls, wobei das Verfahren die folgenden Schritte umfasst:
a) Bereitstellen einer Leiterplatte, die mit zumindest einer Lichteinheit bestückt ist, wobei die Leiterplatte zumindest eine Abstandselementaufnahmeöffnung aufweist, die die Leiterplatte durchsetzt und zur Aufnahme eines Abstandselementes eingerichtet ist,
b) Bereitstellen zumindest eines Abstandselements, wobei das zumindest eine Abstandselement zumindest zwei Abschnitte aufweist, nämlich einen die Abstandselementaufnahmeöffnung durchsetzenden Halteabschnitt sowie zumindest einen an einem Ende des Halteabschnitts angeordneten Stützabschnitt, der im Vergleich zu dem Halteabschnitt verbreitert ist,
c) Einsetzen des zumindest einen Abstandselements in die zumindest eine Abstandselementaufnahmeöffnung,
d) Herstellen einer Verbindung des zumindest einen Abstandshaltelements mit der zumindest einen Abstandselementaufnahmeöffnung, die das zumindest eine Abstandselement gegen eine Verschiebung in eine Normalrichtung zur Leiterplatte sichert,
e) Positionieren eines Lichtleiters, welcher eine Lichteintrittsfläche aufweist, dergestalt an der Leiterplatte, dass die Lichteintrittsfläche der Lichteinheit zur Aufnahme von Licht zugewandt ist, wobei die Lichteintrittsfläche des Lichtleiters von zumindest einem Abstützbereich des Lichtleiters umgeben ist, welcher Abstützbereich des Lichtleiters an der Stützfläche des Abstandselements zur Festlegung eines definierten Normalabstands der Lichteintrittsfläche des Lichtleiters in Bezug auf die Lichteinheit abgestützt ist.

Die Verbindung gemäß Schritt d) kann z.B. durch Kleben, Heißverstemmen oder mechanische Spreizung erfolgen.

Insbesondere kann vorgesehen sein, dass der Lichtleiter in der Position gemäß Schritt e) in Bezug auf die Leiterplatte räumlich fixiert wird. Dies kann z.B. durch feste Verbindung in einem gemeinsamen Gehäuse, an der Leiterplatte und/oder anderen Komponenten, die in Bezug auf die Leiterplatte ortsfest mit dieser verbunden sind, erfolgen.

Weiters kann vorgesehen sein, dass das Einsetzen des zumindest einen Abstandselements in Schritt c) automatisiert unter Verwendung einer optischen Erfassung der zumindest einen Abstandselementaufnahmeöffnung erfolgt. So können z.B. vorgebbare geometrische Form und Größe von Öffnungen an der Leiterplatte exklusiv für Abstandselementaufnahmeöffnungen vorgesehen sein, z.B. in Form von kreisrunden Löchern mit bestimmtem Durchmesser, der dadurch automatisch erkannt und zugeordnet werden kann.

Der Stützabschnitt des Abstandselements kann auch oval bzw. in seinem Querschnitt entsprechend der Form eines Langloches (d.h. so, dass er ein Langloch formschließend ausfüllen kann) ausgebildet sein. Eine ovale- bzw. langlochförmige Ausführung hat den Vorteil, dass in Längsrichtung der geometrischen Form des Stützabschnitts mehr Toleranz hinsichtlich der Positionierung geschaffen wird, und in Schmalrichtung weniger Platz durch das Abstandselement benötigt wird. Dies ist dann von besonderem Vorteil, wenn bei der Bestückung oder Fertigung unterschiedliche Genauigkeiten/Toleranzen in die beiden unterschiedlichen Richtungen der Leiterplattenebene vorliegen und durch entsprechende Formgestaltung und Positionierung der Stützabschnitte darauf reagiert werden kann.

Die Erfindung ist im Folgenden anhand einer beispielhaften und nicht einschränkenden Ausführungsform näher erläutert, die in den Figuren veranschaulicht ist. Darin zeigt
- Figur 1a: eine schematische Darstellung eines erfindungsgemäßen Lichtmoduls ohne Lichtleiter,
- Figur 1b: das Lichtmodul gemäß Fig. 1a in einer Ansicht von schräg unten,
- Figur 1c: eine Draufsicht des Lichtmoduls gemäß Fig. 1a und 1b,
- Figur 2a: eine perspektivische Ansicht des Lichtmoduls gemäß Fig. 1a bis 1c inkl. Lichtleiter,
- Figur 2b: eine Schnittdarstellung des Lichtmoduls gemäß Fig. 2a,
- Figur 3: eine perspektivische Darstellung des Lichtmoduls nach Fig. 2a inkl. Kühlkörper,
- Figur 4: eine perspektivische Darstellung des Lichtmoduls nach Fig. 3 inkl. einem Ausschnitt iner Rahmenstruktur,
- Figur 5a: eine schematische Darstellung eines beispielhaften Bestückungsvorganges, und
- Figur 5b: eine Schnittdarstellung eines beispielhaften Verbindungsvorganges.

In den folgenden Figuren bezeichnen - sofern nicht anders angegeben - gleiche Bezugszeichen gleiche Merkmale.

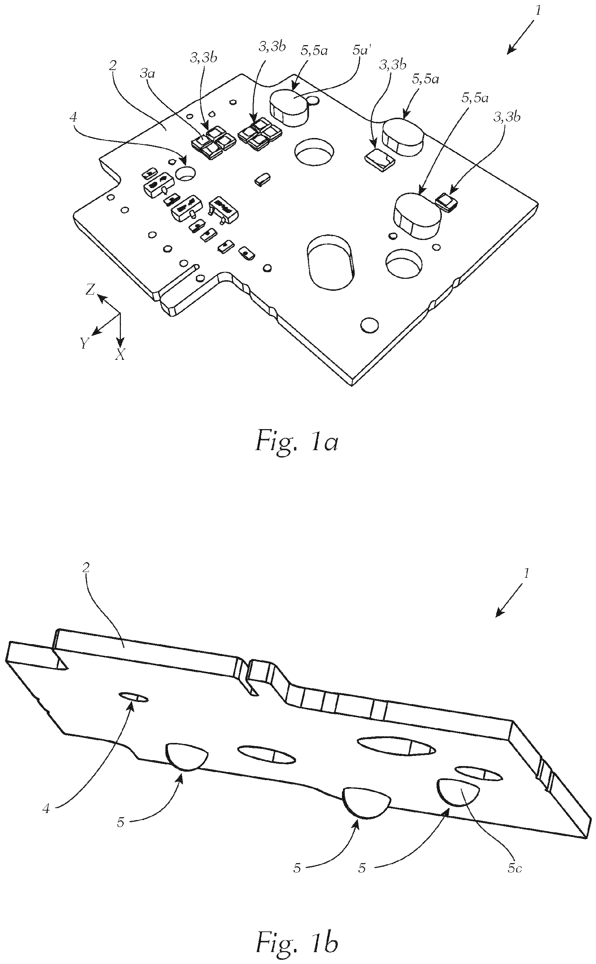

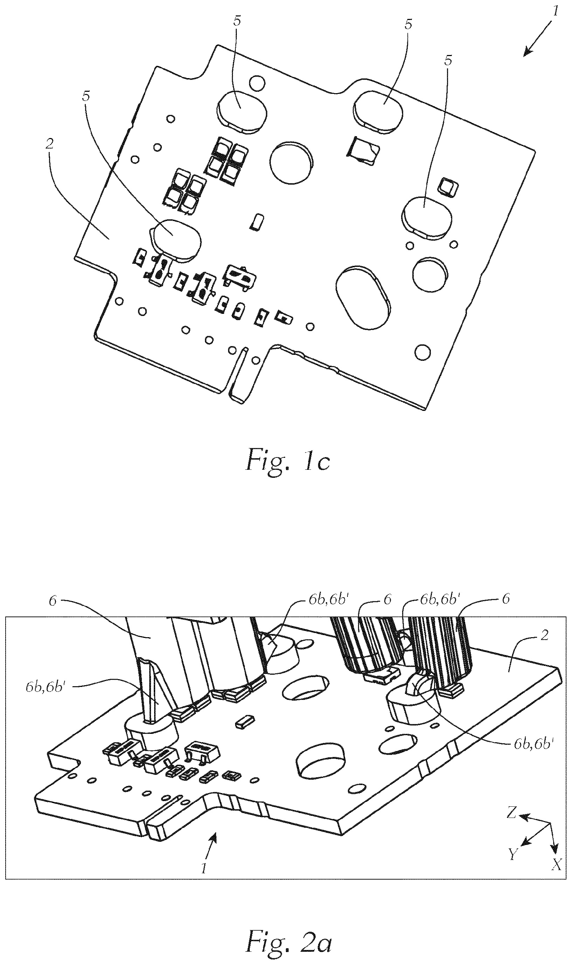

Fig. 1a zeigt eine schematische Darstellung eines erfindungsgemäßen Lichtmoduls 1 ohne Lichtleiter 6 (ab Fig. 2a gezeigt). Das Lichtmodul 1 ist für die Anwendung an/in einem Kraftfahrzeug geeignet und kann insbesondere in einem Kraftfahrzeugscheinwerfer eingesetzt werden. Das Lichtmodul 1 umfasst eine Leiterplatte 2 sowie zumindest eine an einer Seite der Leiterplatte 2 flächig angeordnete Lichteinheit 3 mit einer Lichtaustrittsfläche 3a zur Abstrahlung von Licht. Vorliegend weist die Lichteinheit 3 beispielhaft LED-Lichtquellen 3b auf, wobei in einem linken oberen Bereich der Fig. 1a zwei Vierergruppen gezeigt sind, und rechts davon zwei einzelne LEDs 3b gezeigt sind. Durch die Seite der Leiterplatte 2, an der die Lichtquellen 3b angeordnet sind, wird eine Leiterplattenebene yz ausgebildet. Orthogonal dazu ist die Achse x orientiert, die somit normal von der Leiterplattenebene yz absteht.

In Fig. 1a und 1b wurde bewusst eines von in diesem Beispiel grundsätzlich vorgesehenen vier Abstandselementen 5 nicht dargestellt, um zu zeigen, dass die Leiterplatte 2 Abstandselementaufnahmeöffnungen 4 aufweist, und zwar für jedes Abstandselement 5 eine zugehörige Öffnung 4. Diese Öffnungen 4 sind in der Umgebung einer zugehörigen Lichteinheit 3 angeordnet, wobei die zumindest eine Abstandselementaufnahmeöffnung 4 die Leiterplatte 2 durchsetzt und zur Aufnahme eines Abstandselementes 5 eingerichtet ist.

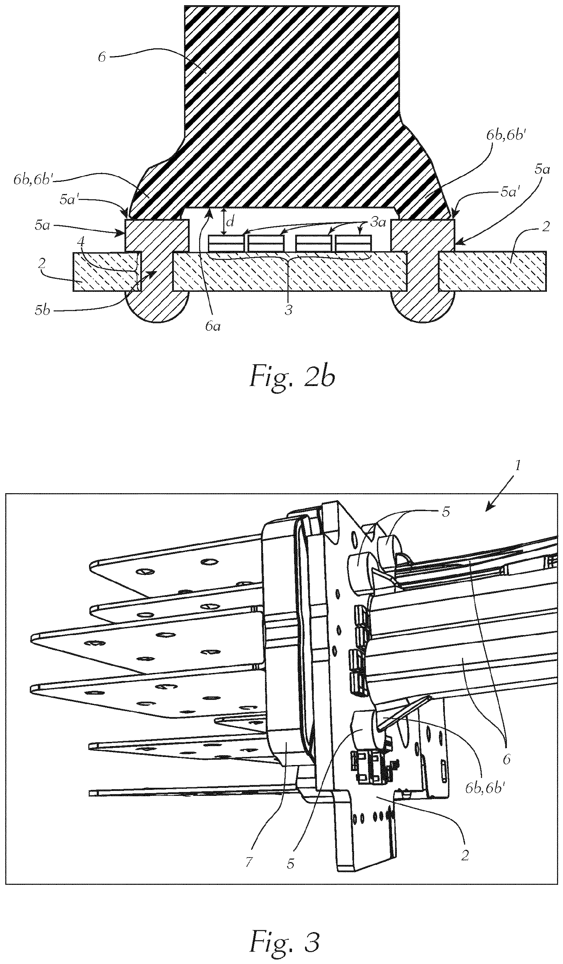

Wie bereits erwähnt, weist das Lichtmodul 1 ferner Abstandselemente 5 auf, die jeweils in einer Abstandselementaufnahmeöffnung 4 angeordnet sind. Das zumindest eine Abstandselement 5 weist zumindest zwei Abschnitte auf, nämlich einen die Abstandselementaufnahmeöffnung 4 durchsetzenden Halteabschnitt 5b (siehe Fig. 2b) sowie zumindest einen an einem Ende des Halteabschnitts 5b angeordneten Stützabschnitt 5a, der im Vergleich zu dem Halteabschnitt 5b verbreitert ist und das Abstandselement 5 gegen ein Durchschieben durch die Abstandselementaufnahmeöffnung 4 sichert. Der Stützabschnitt 5a ist an der gleichen Seite der Leiterplatte 2 wie die zumindest eine Lichteinheit 3 angeordnet. An seinem der Leiterplatte 2 abgewandten Ende ist er durch eine ebene Stützfläche 5a' begrenzt. Diese Stützfläche 5a' ist im Wesentlichen parallel zur Leiterplattenebene yz orientiert. Es kann vorgesehen sein, dass das Lichtmodul 1 zwei oder mehr Lichteinheiten 3 aufweist, wobei den zwei oder mehr Lichteinheiten 3 je zumindest eine, zwei oder mehr Abstandselementaufnahmeöffnungen 4 mit je einem darin aufgenommenen Abstandselement 5 und je ein Lichtleiter 6 zugeordnet sind.

In Fig. 1b ist zudem erkennbar, dass das Abstandselement 5 zudem einen Sicherungsabschnitt 5c aufweist, welcher Sicherungsabschnitt 5c an dem dem Stützabschnitt 5a gegenüberliegenden Ende des Halteabschnitts 5b angeordnet ist, wobei der Sicherungsabschnitt 5c gegenüber dem Halteabschnitt 5b verbreitert ist. Die Verbreiterung kann z.B. durch Spreizen oder Heißverstemmen erreicht werden.

Fig. 2a zeigt eine perspektivische Ansicht des Lichtmoduls 1 gemäß Fig. 1a bis 1c inkl. Lichtleiter 6. Das Lichtmodul 1 weist hierbei beispielhaft drei Lichtleiter 6 auf. Jeder Lichtleiter weist eine Lichteintrittsfläche 6a (siehe Fig. 2b) auf, die der betreffenden Lichteinheit 3 zur Aufnahme von Licht zugewandt ist. Die Lichteintrittsfläche 6a des Lichtleiters 6 wird von zumindest einem Abstützbereich 6b des Lichtleiters 6 zumindest teilweise umgeben. Der Abstützbereich 6b des Lichtleiters 6 ist an der Stützfläche 5a' des Abstandselements 5 zur Festlegung eines definierten Normalabstands d der Lichteintrittsfläche 6a des Lichtleiters 6 in Bezug auf die Lichteinheit 3 abgestützt.

Figur 2b zeigt eine Schnittdarstellung des Lichtmoduls 1 gemäß Fig. 2a. In Fig. 2a und Fig. 2b ist erkennbar, dass der Stützabschnitt 5a des Abstandselements 5 weiter in Normalrichtung zur Leiterplattenebene yz von der Leiterplatte 2 absteht als die Lichtaustrittsfläche 3a der Lichteinheit 3, sodass die Stützfläche 5a' die Lichtaustrittfläche 3a in Normalrichtung -x überragt. Zudem ist beispielhaft erkennbar, dass vorgesehen sein kann, dass im Abstützbereich 6b des Lichtleiters 6 zumindest ein Vorsprung 6b', vorzugweise zwei Vorsprünge 6b' angeordnet sind, die in Richtung der Stützfläche 5a' des Abstandshaltelements 5 von dem Lichtleiter 6 abstehen und sich an der Stützfläche 5a' abstützen. Der Halteabschnitt 5b des Abstandselements 5 ist vorzugsweise dergestalt ausgebildet, dass dieser die Abstandselementaufnahmeöffnung 4 formschlüssig ausfüllt.

Es kann vorgesehen sein, dass die zumindest eine Lichteinheit 3 von zumindest zwei, vorzugsweise genau zwei, Abstandselementaufnahmeöffnungen 4 umgeben ist, wobei diese Abstandselementaufnahmeöffnungen 4 dergestalt räumlich um die Lichteinheit 3 angeordnet sind, dass im Falle des Vorhandenseins von genau zwei Abstandselementöffnungen 4 in der Umgebung der Lichteinheit 3 der Mittelpunkt einer gedachten Verbindungslinie zwischen den Abstandselementöffnungen 4 mit dem geometrischen Schwerpunkt der Lichtaustrittsfläche 3a der Lichteinheit 3 im Wesentlichen zusammenfällt, und/oder im Falle des Vorhandenseins von drei oder mehr Abstandselementöffnungen 4 in der Umgebung der Lichteinheit 3 der Schwerpunkt eines gedachten Polygons mit dem geometrischen Schwerpunkt der Lichtaustrittsfläche 3a der Lichteinheit 3 im Wesentlichen zusammenfällt, wobei das gedachte Polygon dergestalt gebildet wird, dass jede in der Umgebung der Lichteinheit 3 befindliche Abstandselementöffnung 4 eine Ecke des Polygons bildet und jede Ecke eine gerade Verbindung zu den zwei nächstgelegenen Ecken aufweist. Weiters kann vorgesehen sein, dass der Halteabschnitt 5b des Abstandselements 5 in der Abstandselementaufnahmeöffnung 4 fest fixiert ist.

Figur 3 zeigt eine perspektivische Darstellung des Lichtmoduls 1 nach Fig. 2a inkl. einem Kühlkörper 7, der dazu eingerichtet ist, an der Leiterplatte 2 bzw. den daran angeordneten elektronischen Bauelementen anfallende Verlustwärme abzuführen.

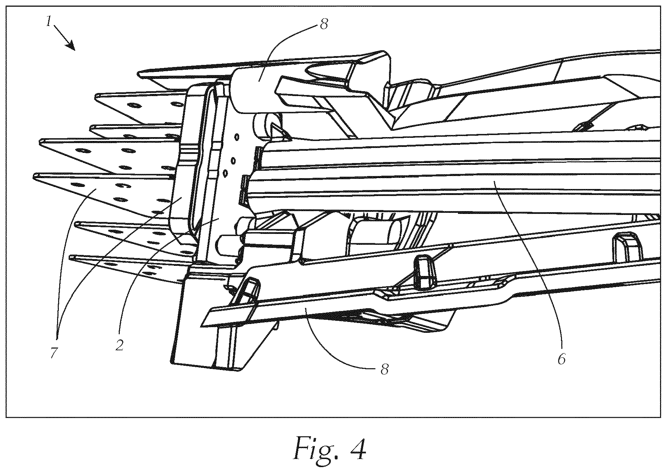

Figur 4 zeigt eine perspektivische Darstellung des Lichtmoduls nach Fig. 3 inkl. einem Ausschnitt einer Rahmenstruktur 8. Diese Rahmenstruktur 8 ist zur Führung und zur zumindest teilweisen Befestigung der Lichtleiter vorgesehen und kann auch einen sichtbaren Teil eines Fahrzeugscheinwerferdesigns bilden.

Weiters betrifft die Erfindung ein Verfahren zum Herstellen eines erfindungsgemäßen Lichtmoduls 1, umfassend die folgenden Schritte:
a) Bereitstellen einer Leiterplatte 2, die mit zumindest einer Lichteinheit 3 bestückt ist, wobei die Leiterplatte 2 zumindest eine Abstandselementaufnahmeöffnung 4 aufweist, die die Leiterplatte 2 durchsetzt und zur Aufnahme eines Abstandselementes 5 eingerichtet ist,
b) Bereitstellen zumindest eines Abstandselements 5, wobei das zumindest eine Abstandselement 5 zumindest zwei Abschnitte aufweist, nämlich einen die Abstandselementaufnahmeöffnung 4 durchsetzenden Halteabschnitt 5b sowie zumindest einen an einem Ende des Halteabschnitts 5b angeordneten Stützabschnitt 5a, der im Vergleich zu dem Halteabschnitt 5b verbreitert ist,
c) Einsetzen des zumindest einen Abstandselements 5 in die zumindest eine Abstandselementaufnahmeöffnung 4,
d) Herstellen einer Verbindung des zumindest einen Abstandshaltelements 5 mit der zumindest einen Abstandselementaufnahmeöffnung 4, die das zumindest eine Abstandselement 5 gegen eine Verschiebung in eine Normalrichtung x zur Leiterplatte 2 sichert,
e) Positionieren eines Lichtleiters 6, welcher eine Lichteintrittsfläche 6a aufweist, dergestalt an der Leiterplatte 2, dass die Lichteintrittsfläche 6a der Lichteinheit 3 zur Aufnahme von Licht zugewandt ist, wobei die Lichteintrittsfläche 6a des Lichtleiters 6 von zumindest einem Abstützbereich 6b des Lichtleiters 6 umgeben ist, welcher Abstützbereich 6b des Lichtleiters 6 an der Stützfläche 5a' des Abstandselements 5 zur Festlegung eines definierten Normalabstands d der Lichteintrittsfläche 6a des Lichtleiters 6 in Bezug auf die Lichteinheit 3 abgestützt ist.

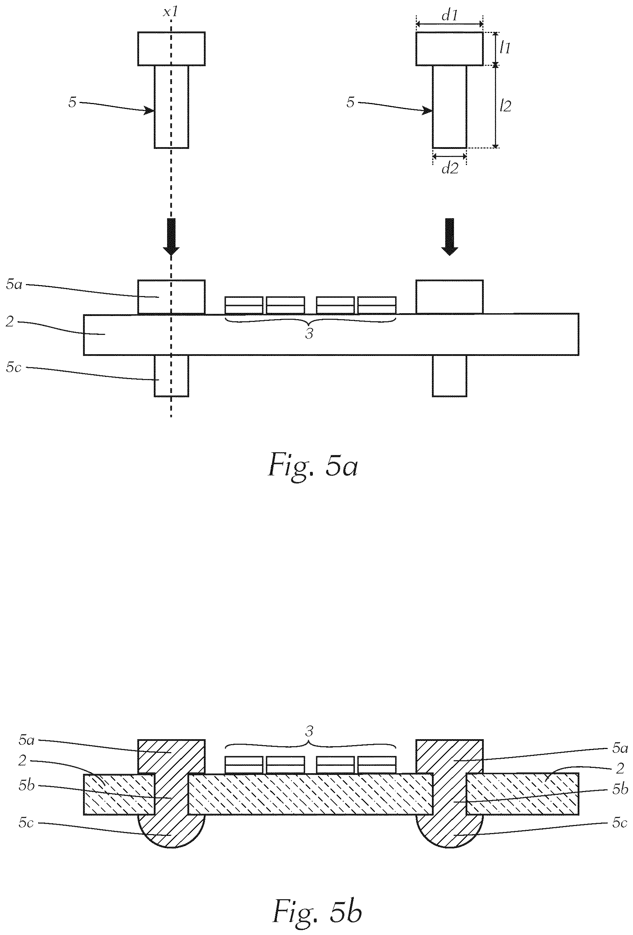

Das Verbinden gemäß Schritt d) ist in der in Fig. 5b und 1b gezeigten Ausführungsform beispielsweise durch Heißverstemmen vorgenommen worden. Zudem kann vorgesehen sein, dass der Lichtleiter 6 in der Position gemäß Schritt e) in Bezug auf die Leiterplatte 2 räumlich fixiert wird. Diese Fixierung kann durch feste Verbindung mit diversen Komponenten erfolgen, die ortsfest mit der Leiterplatte 2 verbunden sind. So kann die Verbindung über ein gemeinsames Gehäuse, direkt an der Leiterplatte und/oder anderen Komponenten, wie beispielsweise dem Rahmenelement 8 erfolgen.

Figur 5a zeigt eine schematische Darstellung eines beispielhaften Bestückungsvorganges, d.h. eines Vorganges, in dem die Abstandselemente 5 in die Leiterplatte 2 eingesetzt werden. Es kann vorgesehen sein, dass der Stützabschnitt 5a und der Halteabschnitt 5b des Abstandselements 5 jeweils im Wesentlichen zylindrisch mit einer gemeinsamen Längsachse x1 ausgebildet sind. Vorzugsweise ist vorgesehen, dass das Einsetzen des zumindest einen Abstandselements 5 in Schritt c) automatisiert unter Verwendung einer optischen Erfassung der zumindest einen Abstandselementaufnahmeöffnung 4 erfolgt. Fig. 5a zeigt die Abstandselemente 5 in zwei Positionen - einmal oberhalb der Leiterplatte 2, und einmal in einem bereits eingesetzten - aber noch nicht fixierten - Zustand. Figur 5b zeigt im Anschluss eine Schnittdarstellung eines beispielhaften Verbindungsvorganges, der durch Heißverstemmen erfolgen kann.

Mit Blick auf Fig. 5a seien noch beispielhafte Abmessungen im Zusammenhang mit dem Abstandshalteelement 5 (im unverstemmten Zustand) erwähnt:
Es kann vorgesehen sein, dass die Abstandselementaufnahmeöffnung 4 als Bohrung mit einem kreisrunden Lochdurchmesser zwischen 1 mm und 2 mm ausgebildet ist und dass die Querschnittsfläche des Stützabschnitts 5a zumindest das Vierfache der Querschnittsfläche des Halteabschnitts 5b des Abstandselements 5 beträgt. Es kann vorgesehen sein, dass das Abstandshalteelement 5 im Bereich des Stützabschnitts 5a einen Durchmesser d1 zwischen 2,5 und 6 mm aufweist, wobei der Durchmesser typischerweise ca. 2,5 mm beträgt. Es kann vorgesehen sein, dass das Abstandshalteelement 5 im Bereich des Halteabschnitts 5b einen Durchmesser d2 zwischen 0,8 und 1,5 mm aufweist, wobei der Durchmesser typischerweise ca. 1 mm beträgt. Die Länge 11 des Stützabschnitts 5a kann z.B. zwischen 1,4 und 2,5 mm betragen und beträgt typischerweise ca.1,5 mm. Die Länge l2 des Halteabschnitts 5a kann z.B. zwischen 3,5 und 5 mm betragen und beträgt typischerweise ca. 4,5mm.

Es kann zudem vorgesehen sein, dass der Abstand zwischen einer Abstandselementaufnahmeöffnung 4 und dem nächstgelegenen Punkt einer zugeordneten Lichteinheit 6 maximal 3 mm, insbesondere zwischen 1,5 mm und 3 mm, beträgt.

Die Erfindung ist nicht auf die gezeigten Ausführungsformen beschränkt, sondern durch den gesamten Schutzumfang der Ansprüche definiert. Auch können einzelne Aspekte der Erfindung bzw. der Ausführungsformen aufgegriffen und miteinander kombiniert werden. Etwaige Bezugszeichen in den Ansprüchen sind beispielhaft und dienen nur der einfacheren Lesbarkeit der Ansprüche, ohne diese einzuschränken.

## Patentansprüche

1. Lichtmodul (1) für ein Kraftfahrzeug, insbesondere einen Kraftfahrzeugscheinwerfer, wobei das Lichtmodul (1) Folgendes umfasst:
- eine Leiterplatte (2),
- zumindest eine an einer Seite der Leiterplatte (2) flächig angeordnete Lichteinheit (3) mit einer Lichtaustrittsfläche (3a) zur Abstrahlung von Licht, wobei die Lichteinheit (3) vorzugsweise zumindest eine LED-Lichtquelle (3b) umfasst, wobei durch die besagte Seite der Leiterplatte (2) eine Leiterplattenebene (yz) ausgebildet wird, sowie
- zumindest einen Lichtleiter (6), **dadurch gekennzeichnet, dass**
die Leiterplatte (2) zumindest eine Abstandselementaufnahmeöffnung (4) aufweist, die in der Umgebung der zumindest einen Lichteinheit (3) angeordnet ist, wobei die zumindest eine Abstandselementaufnahmeöffnung (4) die Leiterplatte (2) durchsetzt und zur Aufnahme eines Abstandselementes (5) eingerichtet ist,
wobei das Lichtmodul (1) ferner zumindest ein Abstandselement (5) aufweist, das in zumindest einer Abstandselementaufnahmeöffnung (4) angeordnet ist, wobei das zumindest eine Abstandselement (5) zumindest zwei Abschnitte aufweist, nämlich einen die Abstandselementaufnahmeöffnung (4) durchsetzenden Halteabschnitt (5b) sowie zumindest einen an einem Ende des Halteabschnitts (5b) angeordneten Stützabschnitt (5a), der im Vergleich zu dem Halteabschnitt (5b) verbreitert ist und das Abstandselement (5) gegen ein Durchschieben durch die Abstandselementaufnahmeöffnung (4) sichert, wobei der Stützabschnitt (5a) an der gleichen Seite der Leiterplatte (2) wie die zumindest eine Lichteinheit (3) angeordnet und an seinem der Leiterplatte (2) abgewandten Ende durch eine ebene Stützfläche (5a') begrenzt ist, wobei diese Stützfläche (5a') im Wesentlichen parallel zur Leiterplattenebene (yz) orientiert ist,
wobei der Lichtleiter (6) eine Lichteintrittsfläche (6a) aufweist, die der Lichteinheit (3) zur Aufnahme von Licht zugewandt ist, wobei die Lichteintrittsfläche (6a) des Lichtleiters (6) von zumindest einem Abstützbereich (6b) des Lichtleiters (6) zumindest teilweise umgeben ist, welcher Abstützbereich (6b) des Lichtleiters (6) an der Stützfläche (5a') des Abstandselements (5) zur Festlegung eines definierten Normalabstands (d) der Lichteintrittsfläche (6a) des Lichtleiters (6) in Bezug auf die Lichteinheit (3) abgestützt ist.

2. Lichtmodul (1) nach Anspruch 1, wobei der Stützabschnitt (5a) des Abstandselements (5) weiter in Normalrichtung (-x) zur Leiterplattenebene (yz) von der Leiterplatte (2) absteht als die Lichtaustrittsfläche (3a) der Lichteinheit (3), sodass die Stützfläche (5a') die Lichtaustrittfläche (3a) in Normalrichtung (-x) überragt.

3. Lichtmodul (1) nach einem der vorhergehenden Ansprüche, wobei im Abstützbereich (6b) des Lichtleiters (6) zumindest ein Vorsprung (6b'), vorzugweise zwei Vorsprünge (6b') ausgebildet sind, die in Richtung der Stützfläche (5a') des Abstandselements (5) von dem Lichtleiter (6) abstehen und sich an der Stützfläche (5a') abstützen.

4. Lichtmodul (1) nach einem der vorhergehenden Ansprüche, wobei der Halteabschnitt (5b) des Abstandselements (5) dergestalt ausgebildet ist, dass dieser die Abstandselementaufnahmeöffnung (4) formschlüssig ausfüllt.

5. Lichtmodul (1) nach einem der vorhergehenden Ansprüche, wobei die zumindest eine Lichteinheit (3) von zumindest zwei, vorzugsweise genau zwei, Abstandselementaufnahmeöffnungen (4) umgeben ist, wobei diese Abstandselementaufnahmeöffnungen (4) dergestalt räumlich um die Lichteinheit (3) angeordnet sind, dass
*im Falle des Vorhandenseins von genau zwei Abstandselementöffnungen (4) in der Umgebung der Lichteinheit (3) der Mittelpunkt einer gedachten Verbindungslinie zwischen den Abstandselementöffnungen (4) mit dem geometrischen Schwerpunkt der Lichtaustrittsfläche (3a) der Lichteinheit (3) im Wesentlichen zusammenfällt, und/oder
*im Falle des Vorhandenseins von drei oder mehr Abstandselementöffnungen (4) in der Umgebung der Lichteinheit (3) der Schwerpunkt eines gedachten Polygons mit dem geometrischen Schwerpunkt der Lichtaustrittsfläche (3a) der Lichteinheit (3) im Wesentlichen zusammenfällt, wobei das gedachte Polygon dergestalt gebildet wird, dass jede in der Umgebung der Lichteinheit (3) befindliche Abstandselementöffnung (4) eine Ecke des Polygons bildet und jede Ecke eine gerade Verbindung zu den zwei nächstgelegenen Ecken aufweist.

6. Lichtmodul (1) nach einem der vorhergehenden Ansprüche, wobei das Lichtmodul (1) zwei oder mehr Lichteinheiten (3) aufweist, wobei den zwei oder mehr Lichteinheiten (3)
• je zumindest eine, zwei oder mehr Abstandselementaufnahmeöffnungen (4) mit je einem darin aufgenommenen Abstandselement (5) und
• je ein Lichtleiter (6) zugeordnet sind.

7. Lichtmodul (1) nach einem der vorhergehenden Ansprüche, wobei der Stützabschnitt (5a) und der Halteabschnitt (5b) des Abstandselements (5) jeweils im Wesentlichen zylindrisch mit einer gemeinsamen Längsachse (x1) ausgebildet sind.

8. Lichtmodul (1) nach einem der vorhergehenden Ansprüche, wobei der Abstand zwischen einer Abstandselementaufnahmeöffnung (4) und dem nächstgelegenen Punkt einer zugeordneten Lichteinheit (3) maximal 3 mm, insbesondere zwischen 1,5 mm und 3 mm, beträgt.

9. Lichtmodul (1) nach einem der vorhergehenden Ansprüche, wobei die Abstandselementaufnahmeöffnung (4) als Bohrung mit einem kreisrunden Lochdurchmesser zwischen 1 mm und 2 mm ausgebildet ist.

10. Lichtmodul (1) nach einem der vorhergehenden Ansprüche, wobei die Querschnittsfläche des Stützabschnitts (5a) zumindest das Vierfache der Querschnittsfläche des Halteabschnitts (5b) des Abstandselements (5) beträgt.

11. Lichtmodul (1) nach einem der vorhergehenden Ansprüche, wobei der Halteabschnitt (5b) des Abstandselements (5) in der Abstandselementaufnahmeöffnung (4) fest fixiert ist.

12. Lichtmodul (1) nach einem der vorhergehenden Ansprüche, wobei das Abstandselement (5) zudem einen Sicherungsabschnitt (5c) aufweist, welcher Sicherungsabschnitt (5c) an dem dem Stützabschnitt (5a) gegenüberliegenden Ende des Halteabschnitts (5b) angeordnet ist, wobei der Sicherungsabschnitt (5c) gegenüber dem Halteabschnitt (5b) verbreitert ist.

13. Verfahren zum Herstellen eines Lichtmoduls (1) nach einem der vorhergehenden Ansprüche, umfassend die folgenden Schritte:
a) Bereitstellen einer Leiterplatte (2), die mit zumindest einer Lichteinheit (3) bestückt ist, wobei die Leiterplatte (2) zumindest eine Abstandselementaufnahmeöffnung (4) aufweist, die die Leiterplatte (2) durchsetzt und zur Aufnahme eines Abstandselementes (5) eingerichtet ist,
b) Bereitstellen zumindest eines Abstandselements (5), wobei das zumindest eine Abstandselement (5) zumindest zwei Abschnitte aufweist, nämlich einen die Abstandselementaufnahmeöffnung (4) durchsetzenden Halteabschnitt (5b) sowie zumindest einen an einem Ende des Halteabschnitts (5b) angeordneten Stützabschnitt (5a), der im Vergleich zu dem Halteabschnitt (5b) verbreitert ist,
c) Einsetzen des zumindest einen Abstandselements (5) in die zumindest eine Abstandselementaufnahmeöffnung (4),
d) Herstellen einer Verbindung des zumindest einen Abstandshaltelements (5) mit der zumindest einen Abstandselementaufnahmeöffnung (4), die das zumindest eine Abstandselement (5) gegen eine Verschiebung in eine Normalrichtung (x) zur Leiterplatte (2) sichert,
e) Positionieren eines Lichtleiters (6), welcher eine Lichteintrittsfläche (6a) aufweist, dergestalt an der Leiterplatte (2), dass die Lichteintrittsfläche (6a) der Lichteinheit (3) zur Aufnahme von Licht zugewandt ist, wobei die Lichteintrittsfläche (6a) des Lichtleiters (6) von zumindest einem Abstützbereich (6b) des Lichtleiters (6) umgeben ist, welcher Abstützbereich (6b) des Lichtleiters (6) an der Stützfläche (5a') des Abstandselements (5) zur Festlegung eines definierten Normalabstands (d) der Lichteintrittsfläche (6a) des Lichtleiters (6) in Bezug auf die Lichteinheit (3) abgestützt ist.

14. Verfahren nach Anspruch 13, wobei der Lichtleiter (6) in der Position gemäß Schritt e) in Bezug auf die Leiterplatte (2) räumlich fixiert wird.

15. Verfahren nach Anspruch 13 oder 14, wobei das Einsetzen des zumindest einen Abstandselements (5) in Schritt c) automatisiert unter Verwendung einer optischen Erfassung der zumindest einen Abstandselementaufnahmeöffnung (4) erfolgt.
